# EUROPEAN PATENT APPLICATION

(11) **EP 4 513 491 A1**
(43) Date of publication of application: **26.02.2025**
(21) Application number: 24790805.6
(22) Date of filing: 24.05.2024
(51) Int. Cl.: G11C 8/10

(54) **SIGNAL PROCESSING CIRCUIT AND MEMORY**

(30) Priority: 03.07.2023 CN 202310814737
(71) Applicant: CXMT Corporation, Hefei City, Anhui Province 230601 (CN)
(72) Inventor: XIE, Yanpeng, Hefei City, Anhui Province 230601 (CN); HUANG, Zequn, Hefei City, Anhui Province 230601 (CN); HU, Dong, Hefei City, Anhui Province 230601 (CN)
(74) Representative: Gulde & Partner
(86) International application number: PCT/CN2024/095228
(87) International publication number: WO 2025/007675

(57) **Abstract**

Embodiments of the present disclosure provide a signal processing circuit and a memory. A command decoding circuit is included, which includes: a preprocessing circuit, configured to: receive a first chip select signal corresponding to previous one cycle of a current cycle corresponding to a current chip select signal and a first command signal corresponding to the previous one cycle of the current cycle corresponding to signal, and perform a logical operation on the first chip select signal and the first command signal to generate a first chip select identifier signal; and an operation circuit, connected to the preprocessing circuit, and configured to: receive the first chip select identifier signal and the current chip select signal, and generate a decoded command corresponding to the current chip select signal when the current chip select signal is in an enabled state and the first chip select identifier signal is in a disabled state.

## Description

### CROSS-REFERENCE TO RELATED APPLICATIONS

This application claims priority to Chinese Patent Application No. 202310814737.6, filed with the China National Intellectual Property Administration on July 3, 2023 and entitled "SIGNAL PROCESSING CIRCUIT AND MEMORY", which is incorporated herein by reference in its entirety.

### TECHNICAL FIELD

The present disclosure relates to the field of semiconductor technologies, and relates to but is not limited to a signal processing circuit and a memory.

### BACKGROUND

With the continuous development of semiconductor technologies, an increasingly high requirement is put forward for a data transmission speed in the manufacturing and utilization of devices such as computers. To obtain a higher data transmission speed, a series of devices such as memories capable of transmitting data at a double data rate (DDR) have emerged.

In a dynamic random access memory (DRAM), a command/address (CMD/ADD) signal, or briefly referred to as a CA signal, may be utilized as an address to perform sampling, and may be further utilized as a command to perform sampling and decoding.

However, many problems still need to be resolved in a current decoding process.

### SUMMARY

In view of this, embodiments of the present disclosure provide a signal processing circuit and a memory. According to an aspect of the embodiments of the present disclosure, a signal processing circuit is provided. The signal processing circuit includes a command decoding circuit.

The command decoding circuit includes:
a preprocessing circuit, configured to: receive a first chip select signal corresponding to previous one cycle of a current cycle corresponding to a current chip select signal and a first command signal corresponding to the previous one cycle of the current cycle corresponding to signal, and perform a logical operation on the first chip select signal and the first command signal to generate a first chip select identifier signal; and
an operation circuit, connected to the preprocessing circuit, and configured to: receive the first chip select identifier signal and the current chip select signal, and generate a decoded command corresponding to the current chip select signal when the current chip select signal is in an enabled state and the first chip select identifier signal is in a disabled state.

In the foregoing solution, the preprocessing circuit is specifically configured to: receive the first chip select signal and a second chip select signal respectively corresponding to the previous one cycle and previous two cycles of the current cycle corresponding to signal and the first command signal and a second command signal respectively corresponding to the previous one cycle and the previous two cycles of the current cycle corresponding to signal, perform a logical operation on the first chip select signal and the first command signal to generate the first chip select identifier signal, and perform a logical operation on the second chip select signal and the second command signal to generate a second chip select identifier signal; and
the operation circuit is specifically configured to: receive the first chip select identifier signal, the second chip select identifier signal, and the current chip select signal, and generate the decoded command corresponding to the current chip select signal when the current chip select signal is in the enabled state and at least one of the first chip select identifier signal and the second chip select identifier signal is in the disabled state.

In the foregoing solution, a cycle of the current cycle corresponding to signal in a first mode is equal to one preset clock cycle; and a cycle of the current cycle corresponding to signal in a second mode is equal to two preset clock cycles.

In the foregoing solution, the preprocessing circuit includes:
a first preprocessing circuit, configured to: receive a first chip select signal and a first command signal that are in the first mode and a first chip select signal and a first command signal that are in the second mode, and generate first chip select identifier signals respectively corresponding to the first mode and the second mode; and
a second preprocessing circuit, configured to: receive a second chip select signal and a second command signal that are in the first mode and a second chip select signal and a second command signal that are in the second mode, and generate second chip select identifier signals respectively corresponding to the first mode and the second mode.

In the foregoing solution, the first preprocessing circuit includes:
a first chip select identifier generation circuit, configured to: receive the first chip select signal and the first command signal that are in the first mode and the first chip select signal and the first command signal that are in the second mode, and generate first intermediate chip select identifier signals respectively corresponding to the first mode and the second mode;
a first selection circuit, connected to the first chip select identifier generation circuit, and configured to: output the first intermediate chip select identifier signal corresponding to the first mode in the first mode; and output the first intermediate chip select identifier signal corresponding to the second mode in the second mode; and
a first sampling circuit, connected to the first selection circuit, and configured to: sample, for one time, the first intermediate chip select identifier signal output by the first selection circuit, to obtain the first chip select identifier signal corresponding to the first mode, and sample, for two times, the first intermediate chip select identifier signal output by the first selection circuit, to obtain the first chip select identifier signal corresponding to the second mode.

In the foregoing solution, the second preprocessing circuit includes:
a second chip select identifier generation circuit, configured to: receive the second chip select signal and the second command signal that are in the first mode and the second chip select signal and the second command signal that are in the second mode, and generate second intermediate chip select identifier signals respectively corresponding to the first mode and the second mode;
a second selection circuit, connected to the second chip select identifier generation circuit, and configured to: output the second intermediate chip select identifier signal corresponding to the first mode in the first mode; and output the second intermediate chip select identifier signal corresponding to the second mode in the second mode; and
a second sampling circuit, connected to the second selection circuit, and configured to: sample, for one time, the second intermediate chip select identifier signal output by the second selection circuit, to obtain the second chip select identifier signal corresponding to the first mode, and sample, for two times, the second intermediate chip select identifier signal output by the second selection circuit, to obtain the second chip select identifier signal corresponding to the second mode.

In the foregoing solution, the second chip select identifier generation circuit includes:
a first NOR gate, configured to perform a NOR logical operation on the second command signal and the second chip select signal that are in the first mode;
a first NOT gate, configured to perform a NOT logical operation on a logical operation result of the first NOR gate, and output the second intermediate chip select identifier signal corresponding to the first mode; and
a second NOR gate, configured to perform a NOR logical operation on the second command signal and the second chip select signal that are in the second mode, and output the second intermediate chip select identifier signal corresponding to the second mode.

In the foregoing solution, the second chip select signal in the first mode overlaps the first chip select signal in the second mode; and the second command signal in the first mode overlaps the first command signal in the second mode.

The first chip select identifier generation circuit includes:
a third NOR gate, configured to perform a NOR logical operation on the first command signal and the first chip select signal that are in the first mode;
a second NOT gate, configured to perform a NOT logical operation on a logical operation result of the third NOR gate, and output the first intermediate chip select identifier signal corresponding to the first mode; and
a third sampling circuit, configured to sample, for one time, an inverse signal of the second intermediate chip select identifier signal generated by the second chip select identifier generation circuit in the first mode, to obtain the first intermediate chip select identifier signal corresponding to the second mode.

In the foregoing solution, the first chip select identifier generation circuit/the second chip select identifier generation circuit includes:
a third selection circuit, connected to an input terminal of a corresponding NOR gate, and configured to: output a first command/address signal corresponding to the previous one cycle/the previous two cycles of the current cycle corresponding to signal as the first command signal/the second command signal when there is a first layout; and output a second command/address signal corresponding to the previous one cycle/the previous two cycles of the current cycle corresponding to signal as the first command signal/the second command signal when there is a second layout.

In the foregoing solution, the operation circuit includes:
a first operation circuit, connected to both the first preprocessing circuit and the second preprocessing circuit, and configured to: receive the first chip select identifier signal and the second chip select identifier signal that correspond to the first mode, a first mode flag signal, the current chip select signal, and a current command signal, and output a decoding signal corresponding to the current chip select signal or disable a decoding signal corresponding to the current chip select signal, the first mode flag signal representing that the signal processing circuit is in the first mode; and
a second operation circuit, connected to both the first preprocessing circuit and the second preprocessing circuit, and configured to: receive the first chip select identifier signal and the second chip select identifier signal that correspond to the second mode, a second mode flag signal, the current chip select signal, and the current command signal, and output a decoding signal corresponding to the current chip select signal or disable a decoding signal corresponding to the current chip select signal, the second mode flag signal representing that the signal processing circuit is in the second mode.

In the foregoing solution, the first operation circuit/the second operation circuit includes an OR gate, a first NAND gate, a second NAND gate, and a fourth NOR gate.

An input terminal of the OR gate is configured to receive the first chip select identifier signal and the second chip select identifier signal that correspond to the first mode/the second mode, and an output terminal is connected to one input terminal of the first NAND gate.

The other input terminal of the first NAND gate is configured to receive the first mode flag signal/the second mode flag signal, and an output terminal is connected to a first input terminal of the fourth NOR gate.

An input terminal of the second NAND gate is configured to receive the current chip select signal and the current command signal, and an output terminal is connected to a second input terminal of the fourth NOR gate.

An output terminal of the fourth NOR gate is configured to output the decoding signal corresponding to the current chip select signal or disable the decoding signal corresponding to the current chip select signal.

In the foregoing solution, the signal processing circuit further includes a clock processing circuit.

The clock processing circuit is configured to: receive a source clock signal, and output an initial clock signal and an initial complementary clock signal. A clock cycle of the source clock signal is the same as the preset clock cycle, a clock cycle of each of the initial clock signal and the initial complementary clock signal is equal to the clock cycle of the source clock signal, and a phase difference between the initial clock signal and the initial complementary clock signal is 180 degrees.

In the foregoing solution, the signal processing circuit further includes:
a first receiving circuit, configured to: receive the initial clock signal and the initial complementary clock signal, and output a first clock signal and a first complementary clock signal, a clock cycle of each of the first clock signal and the first complementary clock signal being twice the clock cycle of the source clock signal;
a second receiving circuit, configured to: receive a source command/address signal, and output an initial command/address signal; and
a third receiving circuit, configured to: receive a source chip select signal, and output an initial chip select signal.

In the foregoing solution, the signal processing circuit further includes:
a chip select processing circuit, connected to the first receiving circuit and the third receiving circuit, and configured to: receive the initial chip select signal, and sample the initial chip select signal for one time by utilizing the first clock signal/the first complementary clock signal, to obtain the second chip select signal; sample the second chip select signal for one time by utilizing the first clock signal/the first complementary clock signal, to obtain the first chip select signal; and sample the first chip select signal for one time by utilizing the first clock signal/the first complementary clock signal, to obtain the current chip select signal; and
a command/address processing circuit, connected to the first receiving circuit and the second receiving circuit, and configured to: receive the initial command/address signal, and sample the initial command/address signal for one time by utilizing the first clock signal/the first complementary clock signal, to obtain the second command signal; sample the second command signal for one time by utilizing the first clock signal/the first complementary clock signal, to obtain the first command signal; and sample the first command signal for one time by utilizing the first clock signal/the first complementary clock signal, to obtain the current command signal.

According to another aspect of the embodiments of the present disclosure, a memory is further provided. The memory includes the signal processing circuit according to any one of the foregoing solutions.

In the foregoing solution, the memory includes a 5th generation double data rate synchronous dynamic random access memory DDR5.

In the embodiments of the present disclosure, the preprocessing circuit receives the first chip select signal and the first command signal that correspond to the previous one cycle of the current cycle corresponding to signal, and performs a logical operation to obtain the first chip select identifier signal; and the operation circuit jointly determines, based on a status of the first chip select identifier signal and a status of the current chip select signal, whether to generate the decoded command corresponding to the current chip select signal, that is, the decoded command corresponding to the current chip select signal is jointly determined based on at least the current chip select signal and the chip select signal and the command signal that correspond to the previous one cycle of the current cycle corresponding to signal. Therefore, a problem that incorrect decoding is performed in a second cycle of a non-target on-die termination command can be alleviated, thereby increasing a decoding success rate.

### BRIEF DESCRIPTION OF DRAWINGS

FIG. 1 is a schematic diagram of structural composition of a signal processing circuit according to an embodiment of the present disclosure;
FIG. 2 is a schematic diagram of structural composition of a command decoding circuit according to an embodiment of the present disclosure;
FIG. 3 is a schematic diagram 1 of signal timing according to an embodiment of the present disclosure;
FIG. 4 is a schematic diagram 2 of signal timing according to an embodiment of the present disclosure;
FIG. 5 is a schematic diagram 3 of signal timing according to an embodiment of the present disclosure;
FIG. 6 is a schematic diagram 4 of signal timing according to an embodiment of the present disclosure;
FIG. 7 is a schematic diagram of a framework structure of a signal processing circuit according to an embodiment of the present disclosure;
FIG. 8 is a schematic diagram 5 of signal timing according to an embodiment of the present disclosure;
FIG. 9 is a schematic diagram 6 of signal timing according to an embodiment of the present disclosure;
FIG. 10a is a schematic diagram of a structure of a signal processing circuit according to an embodiment of the present disclosure;
FIG. 10b is a schematic diagram of a detailed structure of a command decoding circuit according to an embodiment of the present disclosure;
FIG. 11 is a schematic diagram 7 of signal timing according to an embodiment of the present disclosure;
FIG. 12 is a schematic diagram 8 of signal timing according to an embodiment of the present disclosure;
FIG. 13 is a schematic diagram 9 of signal timing according to an embodiment of the present disclosure;
FIG. 14 is a schematic diagram 10 of signal timing according to an embodiment of the present disclosure; and
FIG. 15 is a schematic diagram of structural composition of a memory according to an embodiment of the present disclosure.

### DESCRIPTION OF EMBODIMENTS

To make the technical solutions and advantages of the embodiments of the present disclosure clearer, the technical solutions of the present disclosure are further described below in detail with reference to the accompanying drawings and the embodiments. Although example implementation methods of the present disclosure are shown in the accompanying drawings, it should be understood that the present disclosure may be implemented in various forms without being limited by the implementations described herein. Instead, these implementations are provided to develop a more thorough understanding of the present disclosure and to fully convey the scope of the present disclosure to a person skilled in the art.

In the following paragraphs, the present disclosure is described more specifically by way of example with reference to the accompanying drawings. The advantages and features of the present disclosure will be clearer from the following description and claims. It should be noted that the accompanying drawings are presented in a highly simplified form and are not to exact scale, and are merely intended to conveniently and clearly assist in describing the embodiments of the present disclosure.

It may be understood that meanings of "on", "over", and "above" in the present disclosure should be understood in the widest way, so that "on" means that it is "on" something with no intermediate feature or layer (that is, directly on something), and further includes the meaning that it is "on" something with an intermediate feature or layer.

In addition, for ease of description, spatially relative terms such as "on", "over", "above", "up", and "upper" may be adopted herein to describe a relationship between an element or feature and another element or feature shown in the figures. The spatially relative terms are intended to cover different orientations of the device in application or operation in addition to the orientation depicted in the accompanying drawings. The apparatus may be oriented in another manner (rotated by 90 degrees or in another orientation), and the spatially relative descriptors adopted herein can likewise be interpreted accordingly.

In the embodiments of the present disclosure, the term "substrate" refers to a material on which a subsequent material layer is added. The substrate itself may be patterned. A material added to the top of the substrate may be patterned or may remain unpatterned. In addition, multiple semiconductor materials may be included by the substrate, e.g., silicon, silicon germanium, germanium, gallium arsenide, and indium phosphide. Alternatively, the substrate may be made of a non-conductive material, e.g., glass, plastic, or a sapphire wafer.

In the embodiments of the present disclosure, the term "layer" refers to a material part including a region having a thickness. The layer may extend over the whole of a lower or upper structure, or may have a range smaller than the range of the lower or upper structure. In addition, the layer may be a region of a homogeneous or heterogeneous continuous structure whose thickness is less than the thickness of a continuous structure. For example, the layer may be located between the top surface and the bottom surface of the continuous structure, or the layer may be between any horizontal surface pair at the top surface and the bottom surface of the continuous structure. The layer may extend horizontally, vertically, and/or along an inclined surface. Multiple sublayers may be included in the layer. For example, one or more conductors and contact sublayers (in which interconnection lines and/or via-hole contacts are formed) and one or more dielectric sublayers may be included in an interconnection layer.

In the embodiments of the present disclosure, the terms "first", "second", and the like are intended to distinguish between similar objects but do not necessarily indicate a specific order or sequence.

The memory in the embodiments of the present disclosure includes but is not limited to a dynamic random access memory. In the following, the dynamic random access memory is taken as an example for description.

In an example of a 5th generation DDR (DDR5, 5th DDR) DRAM, a CA signal may be utilized as an address to perform sampling, and may be further utilized as a command to perform sampling and decoding. The CA signal herein is a general name of various command/address signals in the DRAM, may include command signals such as a row address strobe (RAS), a column address strobe (CAS), a write command (WE, Write), and an active command (ACT, Active), and may further include address signals A13~A0 and the like. In addition, in actual application, a quantity of bits of the address signal included in the command/address signal may be specifically determined based on a specification of the DRAM. This is not limited in the embodiments of the present disclosure.

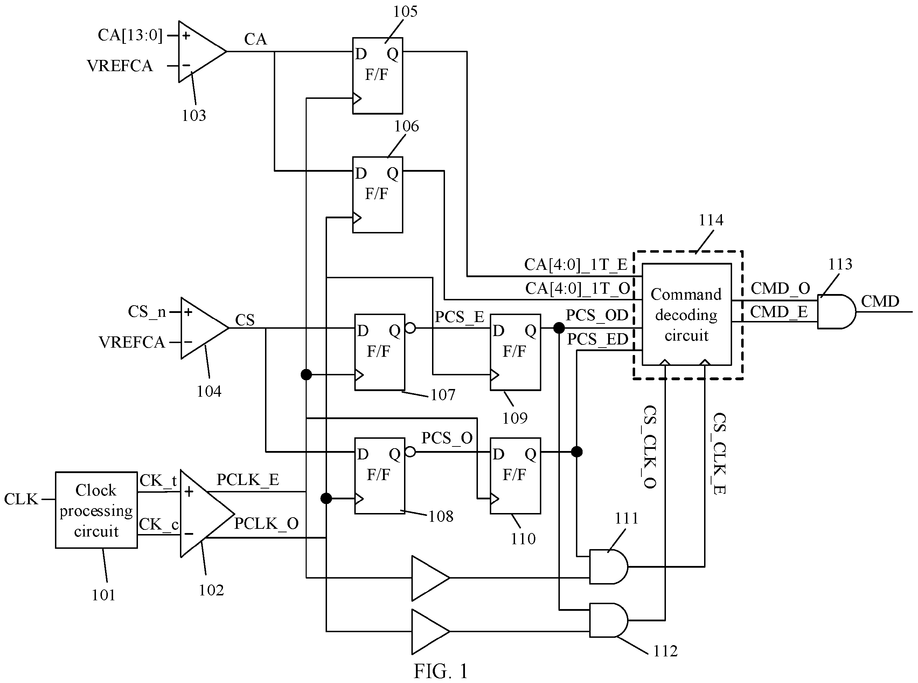

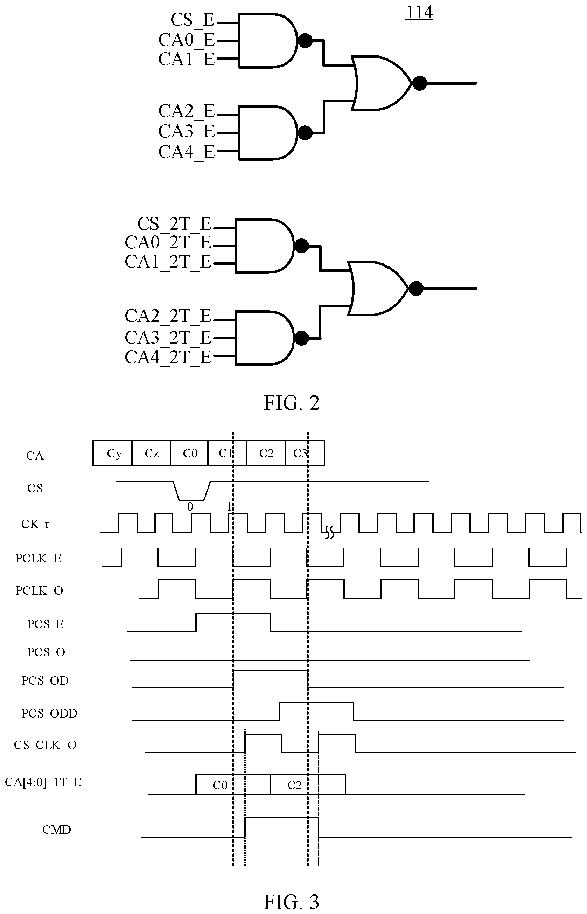

For example, FIG. 1 is a schematic diagram of structural composition of a signal processing circuit. The signal processing circuit includes a clock processing circuit 101, a first receiving circuit 102, a second receiving circuit 103, a third receiving circuit 104, a fourth sampling circuit 105, a fifth sampling circuit 106, a sixth sampling circuit 107, a seventh sampling circuit 108, an eighth sampling circuit 109, a ninth sampling circuit 110, a first AND gate 111, a second AND gate 112, a third AND gate 113, and a command decoding circuit 114. The fourth sampling circuit 105, the fifth sampling circuit 106, the eighth sampling circuit 109, and the ninth sampling circuit 110 each may include a D flip-flop, and the sixth sampling circuit 107 and the seventh sampling circuit 108 each may include a D flip-flop and an inverter. In addition, the command decoding circuit 114 may include logical components such as a three-input NAND gate and a two-input NAND gate. For details, refer to FIG. 2.

In FIG. 1, an input signal of the clock processing circuit 101 is a source clock signal CLK, and output signals are an initial clock signal CK_t and an initial complementary clock signal CK_c; input signals of the first receiving circuit 102 are the initial clock signal CK_t and the initial complementary clock signal CK_c, and output signals are a first clock signal PCLK_E and a first complementary clock signal PCLK_O; input signals of the second receiving circuit 103 are a source command/address signal CA[13:0] and a reference signal VREFCA, and an output signal is an initial command/address signal CA; and input signals of the third receiving circuit 104 are a source chip select signal CS_n and the reference signal VREFCA, and an output signal is an initial chip select signal CS. A chip select processing circuit includes the sixth sampling circuit 107, the seventh sampling circuit 108, the eighth sampling circuit 109, and the ninth sampling circuit 110. The chip select processing circuit receives the initial chip select signal CS, and samples the initial chip select signal CS for one time through the sixth sampling circuit 107 and the seventh sampling circuit 108 by utilizing the first clock signal PCLK_E and the first complementary clock signal PCLK_O, to obtain a first chip select even signal PCS_E and a first chip select odd signal PCS_O; separately samples the first chip select even signal PCS_E and the first chip select odd signal PCS_O through the eighth sampling circuit 109 and the ninth sampling circuit 110 by utilizing the first clock signal PCLK_E and the first complementary clock signal PCLK_O, to obtain a second chip select even signal PCS_ED and a second chip select odd signal PCS_OD; performs a logical operation on the first clock signal PCLK_E and the second chip select even signal PCS_ED through the first AND gate 111, to obtain a third chip select even signal CS_CLK_E, and performs a logical operation on the first complementary clock signal PCLK_O and the second chip select odd signal PCS_OD through the second AND gate 112, to obtain a third chip select odd signal CS_CLK_O; samples the initial command/address signal CA through the fourth sampling circuit 105 by utilizing the first clock signal PCLK E, to obtain an initial command even signal CA[4:0]_1T _E; and samples the initial command/address signal CA through the fifth sampling circuit 106 by utilizing the first complementary clock signal PCLK_O, to obtain an initial command odd signal CA[4:0]_1T_O.

Then, decoding processing is performed on CA[4:0]_1T _E, CA[4:0]_1T_O, PCS_ED, PCS_OD, CS CLK_O, and CS_CLK_E through the command decoding circuit 114, to obtain a command even signal CMD_E and a command odd signal CMD_O. Finally, a logical operation is performed on CMD_E and CMD_O through a logic gate circuit, that is, the third AND gate 113, to obtain a target command signal CMD. It should be noted that CA[13:0] herein represents a group of signals, and is a general name of a combination of CA[0], CA[1], ..., and CA[13]. Correspondingly, the second receiving circuit 103 actually includes 14 receiving circuits and output lines, and even includes 14 subsequent sampling circuits, which are in a one-to-one correspondence with CA[0], CA[1], ..., and CA[13].

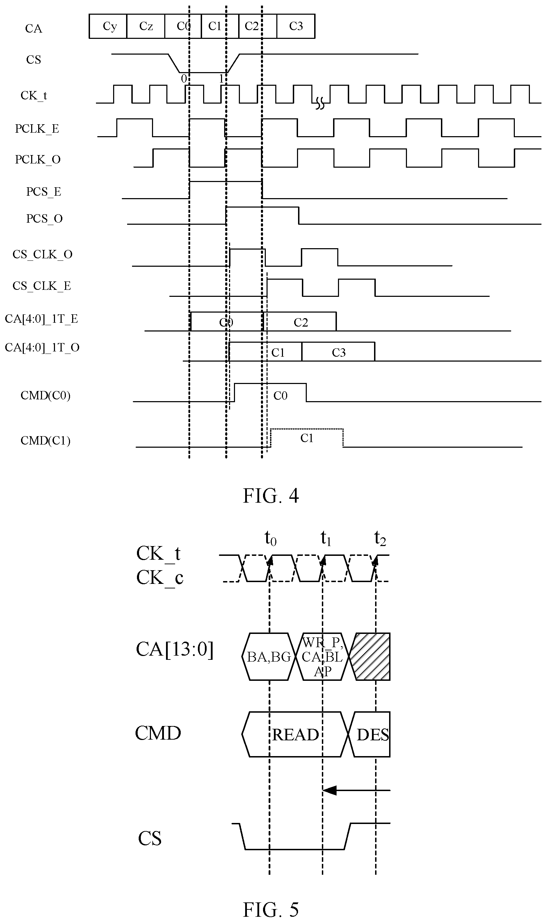

Based on the signal processing circuit shown in FIG. 1, a signal timing diagram corresponding to the signal processing circuit is shown in FIG. 3 and FIG. 4. FIG. 3 is a schematic timing diagram of signals when a valid pulse width of a CS signal is a width of one preset clock cycle. It should be noted that in this embodiment of the present disclosure, the signal processing circuit herein may be applied to a command signal with one preset clock cycle (which is represented by a 1N mode), indicating that the target command signal CMD includes only a valid command with one preset clock cycle, and FIG. 3 is a timing diagram in the 1N mode. The signal processing circuit herein may be further applied to a command signal with two preset clock cycles (which is represented by a 2N mode), indicating that the target command signal CMD includes a valid command with two preset clock cycles, and FIG. 4 is a timing diagram in the 2N mode.

In FIG. 3, the initial clock signal is represented by CK_t, the first clock signal is represented by PCLK E, the first complementary clock signal is represented by PCLK _O, a clock cycle of the signal CK_t is equal to the preset clock cycle, and a clock cycle of each of the signal PCLK_E and the signal PCLK_O is twice the preset clock cycle. The initial command/address signal is represented by CA, and CA may include Cy, Cz, C0, C1, C2, and C3. The initial chip select signal is represented by CS, the first chip select even signal is represented by PCS_E, and the first chip select odd signal is represented by PCS_O. The first chip select even signal obtained after the CS signal is sampled by utilizing a rising edge of the signal PCLK_E is represented by PCS_E, is a valid pulse signal at a high level, and has a pulse width twice that in the preset clock cycle. The first chip select odd signal obtained after the CS signal is sampled by utilizing a rising edge of the signal PCLK_O is represented by PCS_O, and is a low-level signal. The initial command even signal obtained after the CA signal is sampled by utilizing the rising edge of the signal PCLK_E is represented by CA[4:0]_1T _E. A signal PCS_ODD is a signal output after the signal PCS_OD is delayed, and is configured to perform a logical operation with PCS_OD and then perform an AND logical operation with the clock signal PCLK_O to obtain a clock signal CS_CLK_O with two valid pulses. FIG. 4 is a schematic timing diagram of signals when a valid pulse width of a CS signal is a width of two preset clock cycles, that is, in the 2N mode. Details are not described herein again.

In the foregoing embodiment, the initial clock signal CK_t and the initial complementary clock signal CK_c are divided into the first clock signal PCLK_E and the first complementary clock signal PCLK_O after passing through the first receiving circuit 102, to sample the initial command/address signal CA. In DDR5, in a normal command (normal CMD) and a not target on die termination command (NT ODT CMD), a first cycle of a CA signal is utilized as a command and an address, and a second cycle is utilized as the remaining address. Therefore, two stages of D flip-flops are required in a DDR5 design for sampling, and then sampling results are respectively utilized as address information in the two cycles. For the command, a first-stage CA signal needs to be utilized to perform combinational logic to implement decoding, and then a decoded CMD signal needs to be sampled at the second stage to align with a sampling address in the second cycle. Herein, the normal CMD may be understood as a command such as a normal read/write command, and the NT ODT CMD may be understood as a non-target-related command.

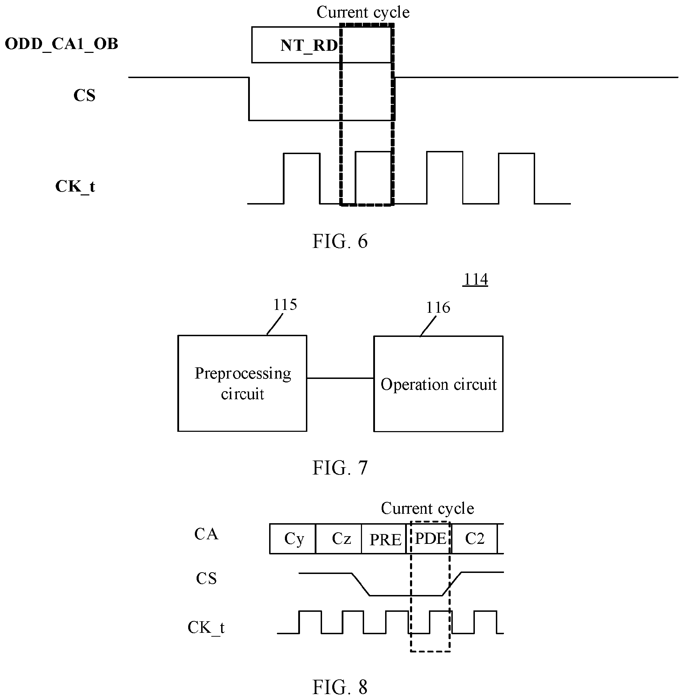

In the foregoing embodiment, simple combinational logic of PCS_ED/PCS_OD and PCLK_E/PCLK_O is applied to generate a sampling command for CS_CLK_O/CS_CLK_E, and then an AND logical operation is performed with PCS_OD/PCS_ED to generate a signal CMD with one pulse. For the normal CMD, decoding is performed when the CS signal is at a low level, and regardless of in the 1N mode or the 2N mode, the CS signal is at a low level only in the first cycle. FIG. 5 shows that in the 1N mode, the CS signal is at a low level in two consecutive preset clock cycles in the case of the NT ODT CMD. Because the CS signal is at a low level in two consecutive cycles in the case of the NT ODT CMD, based on the signal processing circuit provided in the foregoing embodiment, command decoding is incorrectly performed on a CS signal in the second cycle in the case of the NT ODT CMD. With further reference to FIG. 6, for the NT ODT CMD, the CS signal is at a low level in two consecutive cycles. This is utilized as a flag to determine that the signal is the NT ODT CMD. However, in the second cycle in which the CS signal is at a low level, the CS signal is incorrectly utilized as a decoding signal to perform decoding, resulting in incorrect decoding.

Based on the foregoing problem, an embodiment of the present disclosure provides a signal processing circuit. As shown in FIG. 7, the signal processing circuit includes:
a command decoding circuit 114, where the command decoding circuit 114 includes:
a preprocessing circuit 115, configured to: receive a first chip select signal corresponding to previous one cycle of a current cycle corresponding to a current chip select signal and a first command signal corresponding to the previous one cycle of the current cycle corresponding to signal, and perform a logical operation on the first chip select signal and the first command signal to generate a first chip select identifier signal; and
an operation circuit 116, connected to the preprocessing circuit 115, and configured to: receive the first chip select identifier signal and the current chip select signal, and generate a decoded command corresponding to the current chip select signal when the current chip select signal is in an enabled state and the first chip select identifier signal is in a disabled state.

Herein, if it is determined, by utilizing only a status of the current chip select signal and a status of the first chip select signal corresponding to the previous one cycle of a current cycle, whether to perform decoding, a decoding error also occurs. Specifically, when the current chip select signal is at a low level, if the first chip select signal corresponding to the previous one cycle of the current cycle corresponding to signal is at a low level, the decoded command is canceled. In this case, a determining error is also caused. FIG. 8 is a schematic diagram of signal timing in a 1N mode. FIG. 8 shows a case of two consecutive normal CMDs. When it is determined, by utilizing only the status of the current chip select signal and the status of the first chip select signal corresponding to the previous one cycle of the current cycle, whether to perform decoding, a decoded command in a second cycle of the normal CMD is canceled, resulting in incorrect decoding.

It should be noted that herein, the enabled state may be a high-level state, and the disabled state may be a low-level state. Alternatively, the enabled state may be a low-level state, and the disabled state may be a high-level state. This is not limited in this embodiment of the present disclosure. An example in which the enabled state is the low-level state and the disabled state is the high-level state is utilized below for description.

It may be understood that a CA1 signal in a CA signal may be configured to distinguish between the normal CMD and an NT ODT CMD. Specifically, when the CA1 signal is at a high level, there is the normal CMD, or when the CA1 signal is at a low level, there is the NT ODT CMD. In this embodiment of the present disclosure, the preprocessing circuit receives the first chip select signal and the first command signal that correspond to the previous one cycle of the current cycle corresponding to signal, and performs a logical operation to obtain the first chip select identifier signal; and the operation circuit jointly determines, based on a status of the first chip select identifier signal and the status of the current chip select signal, whether to generate the decoded command corresponding to the current chip select signal, that is, the decoded command corresponding to the current chip select signal is jointly determined based on the current chip select signal and the chip select signal and the command signal that correspond to the previous one cycle of the current cycle corresponding to signal. Therefore, a problem that incorrect decoding is performed in a second cycle of the NT ODT CMD can be effectively alleviated.

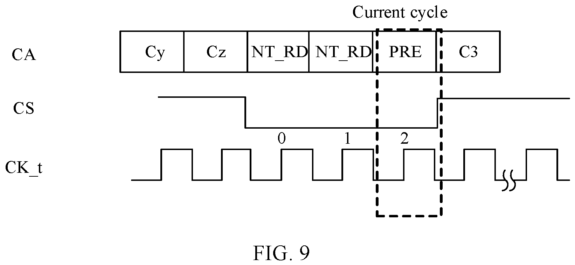

However, in a solution of jointly determining, by utilizing the first command signal and the first chip select signal that correspond to the previous one cycle of the current cycle, and the chip select signal corresponding to the current cycle, whether to generate the decoded command corresponding to the current chip select signal, if the NT ODT CMD is followed by a normal CMD in the 1N mode shown in FIG. 9, the current cycle may be determined as the second cycle of the NT ODT CMD. In this case, the decoded command corresponding to the current chip select signal is canceled, and a decoding error occurs. How to eliminate incorrect decoding in the second cycle of the NT ODT CMD while ensuring that a normal command is decoded, and further increase a decoding success rate becomes an urgent problem to be resolved.

Based on the foregoing problem, an embodiment of the present disclosure further provides the following solution.

In some embodiments, the preprocessing circuit 115 is specifically configured to: receive the first chip select signal and a second chip select signal respectively corresponding to the previous one cycle and previous two cycles of the current cycle corresponding to signal and the first command signal and a second command signal respectively corresponding to the previous one cycle and the previous two cycles of the current cycle corresponding to signal, perform a logical operation on the first chip select signal and the first command signal to generate the first chip select identifier signal, and perform a logical operation on the second chip select signal and the second command signal to generate a second chip select identifier signal; and
the operation circuit 116 is specifically configured to: receive the first chip select identifier signal, the second chip select identifier signal, and the current chip select signal, and generate the decoded command corresponding to the current chip select signal when the current chip select signal is in the enabled state and at least one of the first chip select identifier signal and the second chip select identifier signal is in the disabled state.

It may be understood that in the foregoing embodiment, it is jointly determined, by utilizing the current chip select signal, the first command signal and the first chip select signal that correspond to the previous one cycle of the current cycle, and the second command signal and the second chip select signal that correspond to the previous two cycles of the current cycle, whether to generate the decoded command corresponding to the current chip select signal. Therefore, incorrect decoding in the second cycle of the NT ODT CMD is avoided while it is ensured that the normal CMD is decoded, thereby further increasing the decoding success rate.

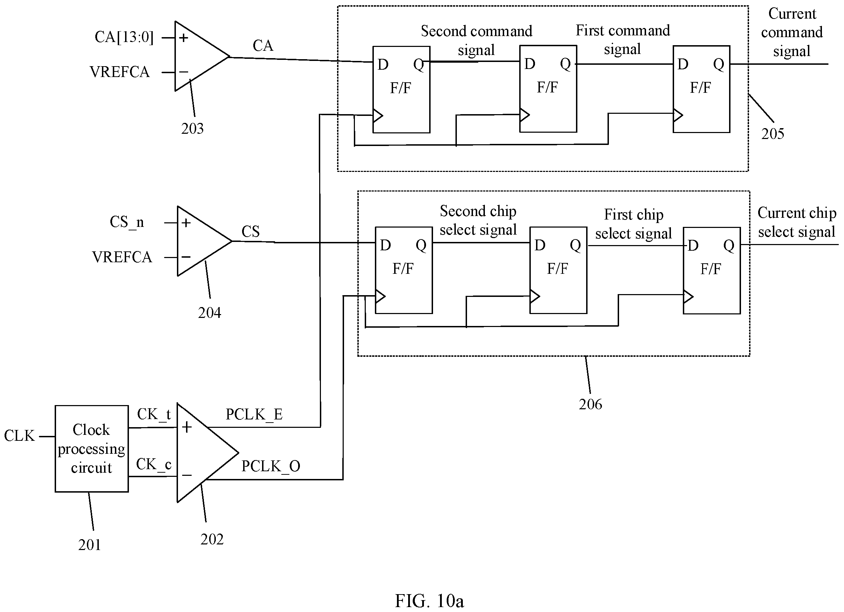

In some embodiments, as shown in FIG. 10a, the signal processing circuit further includes a clock processing circuit 201.

The clock processing circuit 201 is configured to: receive a source clock signal, and output an initial clock signal and an initial complementary clock signal. A clock cycle of the source clock signal is the same as a preset clock cycle, a clock cycle of each of the initial clock signal and the initial complementary clock signal is equal to the clock cycle of the source clock signal, and a phase difference between the initial clock signal and the initial complementary clock signal is 180 degrees.

In some embodiments, as shown in FIG. 10a, the signal processing circuit further includes:
a first receiving circuit 202, configured to: receive the initial clock signal and the initial complementary clock signal, and output a first clock signal and a first complementary clock signal, a clock cycle of each of the first clock signal and the first complementary clock signal being twice the clock cycle of the source clock signal;
a second receiving circuit 203, configured to: receive a source command/address signal, and output an initial command/address signal; and
a third receiving circuit 204, configured to: receive a source chip select signal, and output an initial chip select signal.

It should be noted that in this embodiment of the present disclosure, the first receiving circuit 202, the second receiving circuit 203, or the third receiving circuit 204 may be a receiver (represented by Receiver), or may be a buffer (represented by Buffer).

It should be noted that herein, the source command/address signal may be represented by CA[13:0], and the initial command/address signal is represented by CA; the source chip select signal may be represented by CS_n, and the initial chip select signal is represented by CS; and the initial clock signal and the initial complementary clock signal are respectively represented by CK_t and CK_c, and the first clock signal and the first complementary clock signal are respectively represented by PCLK_E and PCLK_O. The clock cycle of each of the first clock signal and the first complementary clock signal is twice the clock cycle of the source clock signal, and a phase difference between the first clock signal and the first complementary clock signal is 180 degrees. The clock cycle of each of the initial clock signal and the initial complementary clock signal is equal to the clock cycle of the source clock signal, and the phase difference between the initial clock signal and the initial complementary clock signal is 180 degrees.

It should be further noted that in this embodiment of the present disclosure, the source command/address signal or the initial command/address signal is not one signal, but represents a group of command/address signals, that is, CA[0]-CA[13]. Therefore, for the second receiving circuit, 14 receiving circuits may be included herein, and are configured to receive 14 signals such as CA[0], CA[1], ..., and CA[13]. Only one receiving circuit is shown in FIG. 1 as an example.

In some embodiments, as shown in FIG. 10a, the signal processing circuit further includes:
a chip select processing circuit 206, connected to the first receiving circuit 202 and the third receiving circuit 204, and configured to: receive the initial chip select signal, and sample the initial chip select signal for one time by utilizing the first clock signal/the first complementary clock signal, to obtain the second chip select signal; sample the second chip select signal for one time by utilizing the first clock signal/the first complementary clock signal, to obtain the first chip select signal; and sample the first chip select signal for one time by utilizing the first clock signal/the first complementary clock signal, to obtain the current chip select signal; and
a command/address processing circuit 205, connected to the first receiving circuit 202 and the second receiving circuit 203, and configured to: receive the initial command/address signal, and sample the initial command/address signal for one time by utilizing the first clock signal/the first complementary clock signal, to obtain the second command signal; sample the second command signal for one time by utilizing the first clock signal/the first complementary clock signal, to obtain the first command signal; and sample the first command signal for one time by utilizing the first clock signal/the first complementary clock signal, to obtain a current command signal.

It should be noted that clock signals received by the command/address processing circuit 205 and the chip select processing circuit 206 in FIG. 10a are merely examples, and are not configured to limit the present disclosure.

In some embodiments, a cycle of the current cycle corresponding to signal in a first mode is equal to one preset clock cycle; and a cycle of the current cycle corresponding to signal in a second mode is equal to two preset clock cycles.

The signal processing circuit in this embodiment of the present disclosure may be applied to the first mode, and may be further applied to the second mode. A target command signal CMD includes only a valid command with one preset clock cycle in the first mode, and the target command signal CMD includes a valid command with two preset clock cycles in the second mode. The cycle of the current cycle corresponding to signal in the second mode is twice the cycle of the current cycle corresponding to signal in the first mode.

Herein, in the first mode, the current chip select signal is represented by CS_E, the first chip select signal is represented by ODD _CS_1B, the first chip select identifier signal is represented by CS_EVEN_P_B, the second chip select signal is represented by EVEN_CS_1B, and the second chip select identifier signal is represented by CS_EVEN_PP_T. In the second mode, the current chip select signal is represented by CS_2T _E, the first chip select signal is represented by EVEN_CS_1B, the first chip select identifier signal is represented by CS_EVEN_P_B_2N, the second chip select signal is represented by EVEN_CS_0B, and the second chip select identifier signal is represented by CS_EVEN_PP_T_2N.

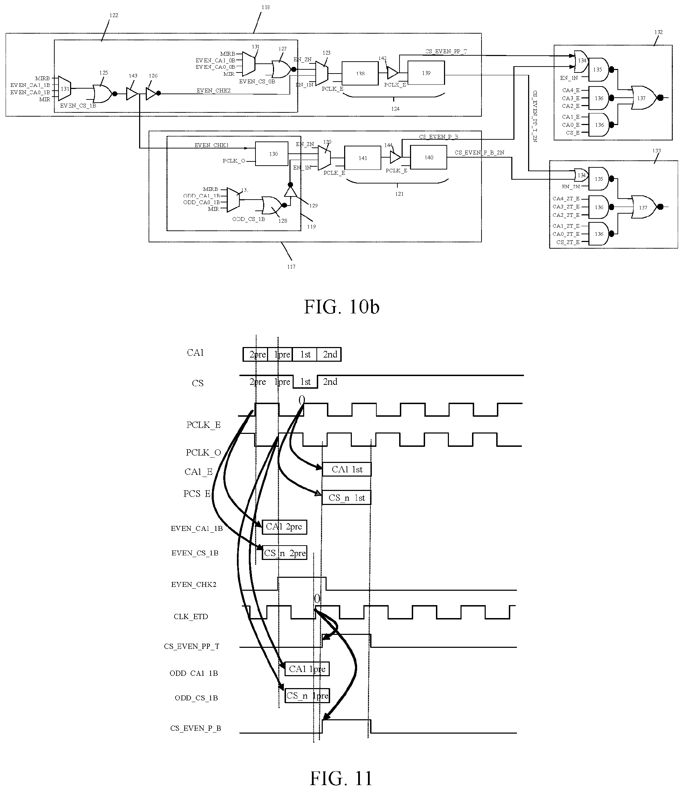

In some embodiments, as shown in FIG. 10b, a first chip select identifier generation circuit 119/a second chip select identifier generation circuit 122 includes:
a third selection circuit 131, connected to an input terminal of a corresponding NOR gate, and configured to: output a first command/address signal corresponding to the previous one cycle/the previous two cycles of the current cycle corresponding to signal as the first command signal/the second command signal when there is a first layout; and output a second command/address signal corresponding to the previous one cycle/the previous two cycles of the current cycle corresponding to signal as the first command signal/the second command signal when there is a second layout.

It may be understood that based on different layouts, CA0 in the 14 signals included in the source command/address signal CA[13:0] may be selected to perform sampling and a logical operation to output the first command signal/the second command signal, or CA1 in the 14 signals included in the source command/address signal CA[13:0] may be selected to perform sampling and a logical operation to output the first command signal/the second command signal. When CA1 is selected as the first command/address signal, in the first mode, the first command signal is represented by ODD _CA1_1B, and the second command signal is represented by EVEN_CA1_1B; and in the second mode, the first command signal is represented by EVEN_CA1_1B, and the second command signal is represented by EVEN_CA1_0B. When CA0 is selected as the first command/address signal, in the first mode, the first command signal is represented by ODD _CA0_1B, and the second command signal is represented by EVEN_CA0_1B; and in the second mode, the first command signal is represented by EVEN_CA0_1B, and the second command signal is represented by EVEN_CA0_0B. It should be noted that only examples in which CA0 or CA1 is utilized as the first command/address signal are listed above. However, this is not limited thereto. In actual application, specific selection may be performed based on different layout designs.

An example in which CA1 is utilized as the first command/address signal is utilized below to describe in detail how to separately implement, in the first mode and the second mode, decoding through the signal processing circuit provided in this embodiment of the present disclosure.

In some embodiments, as shown in FIG. 7 and FIG. 10b, the preprocessing circuit 115 includes:
a first preprocessing circuit 117, configured to: receive a first chip select signal and a first command signal that are in the first mode and a first chip select signal and a first command signal that are in the second mode, and generate first chip select identifier signals respectively corresponding to the first mode and the second mode; and
a second preprocessing circuit 118, configured to: receive a second chip select signal and a second command signal that are in the first mode and a second chip select signal and a second command signal that are in the second mode, and generate second chip select identifier signals respectively corresponding to the first mode and the second mode.

Herein, the first preprocessing circuit 117 mainly performs corresponding processing on the first chip select signals and the first command signals in the first mode and the second mode, to generate the first chip select identifier signals, and the second preprocessing circuit 118 mainly performs corresponding processing on the second chip select signals and the second command signals in the first mode and the second mode, to generate the second chip select identifier signals.

In some embodiments, as shown in FIG. 10b, the second preprocessing circuit 118 includes:
the second chip select identifier generation circuit 122, configured to: receive the second chip select signal and the second command signal that are in the first mode and the second chip select signal and the second command signal that are in the second mode, and generate second intermediate chip select identifier signals respectively corresponding to the first mode and the second mode;
a second selection circuit 123, connected to the second chip select identifier generation circuit 122, and configured to: output the second intermediate chip select identifier signal corresponding to the first mode in the first mode; and output the second intermediate chip select identifier signal corresponding to the second mode in the second mode; and
a second sampling circuit 124, connected to the second selection circuit 123, and configured to: sample, for one time, the second intermediate chip select identifier signal output by the second selection circuit 123, to obtain the second chip select identifier signal corresponding to the first mode, and sample, for two times, the second intermediate chip select identifier signal output by the second selection circuit 123, to obtain the second chip select identifier signal corresponding to the second mode.

Herein, the second intermediate chip select identifier signal corresponding to the first mode is represented by EVEN_CHK2.

Herein, the second selection circuit 123 is further connected to a first mode flag signal EN_1N and a second mode flag signal EN_2N. The first mode flag signal represents that the signal processing circuit is in the first mode, and the second mode flag signal represents that the signal processing circuit is in the second mode. The second selection circuit 123 outputs the second intermediate chip select identifier signal corresponding to the first mode by utilizing the first mode flag signal, and the second selection circuit 123 outputs the second intermediate chip select identifier signal corresponding to the second mode by utilizing the second mode flag signal.

Herein, the second sampling circuit 124 may include a first flip-flop 138, a second flip-flop 139, and a first buffer 142. Each of the first flip-flop 138 and the second flip-flop 139 herein includes a D flip-flop. An input terminal of the first flip-flop 138 is connected to an output terminal of the second selection circuit 123, and receives the second intermediate chip select identifier signal output by the second selection circuit 123, and a clock terminal is connected to the first receiving circuit, and receives the first clock signal, that is, the signal PCLK_E, to generate the second chip select identifier signal CS_EVEN_PP_T corresponding to the first mode. An output terminal of the first flip-flop 138 is connected to an input terminal of the first buffer 142, and is configured to enhance a signal driving capability. An input terminal of the second flip-flop 139 is connected to an output terminal of the first buffer 142, and a clock terminal is connected to the first receiving circuit, and receives the first clock signal, that is, the signal PCLK_E, to generate the second chip select identifier signal CS_EVEN_PP_T_2N corresponding to the second mode.

Composition of the second chip select identifier generation circuit 122 is described below in detail with reference to FIG. 10b.

In some embodiments, the second chip select identifier generation circuit 122 includes:
a first NOR gate 125, configured to perform a NOR logical operation on the second command signal and the second chip select signal that are in the first mode;
a first NOT gate 126, configured to perform a NOT logical operation on a logical operation result of the first NOR gate 125, and output the second intermediate chip select identifier signal corresponding to the first mode; and
a second NOR gate 127, configured to perform a NOR logical operation on the second command signal and the second chip select signal that are in the second mode, and output the second intermediate chip select identifier signal corresponding to the second mode.

In some specific examples, a first input terminal of the first NOR gate 125 is connected to an output terminal of the third selection circuit 131, a second input terminal of the first NOR gate 125 is connected to the chip select processing circuit, and an output terminal of the first NOR gate 125 is connected to an input terminal of a second buffer 143. A signal from the second buffer 143 is divided into two channels, one channel is connected to the first NOT gate 126, and the other channel is connected to the first chip select identifier generation circuit 119.

In some embodiments, as shown in FIG. 10b, the first preprocessing circuit 117 includes:
the first chip select identifier generation circuit 119, configured to: receive the first chip select signal and the first command signal that are in the first mode and the first chip select signal and the first command signal that are in the second mode, and generate first intermediate chip select identifier signals respectively corresponding to the first mode and the second mode;
a first selection circuit 120, connected to the first chip select identifier generation circuit 119, and configured to: output the first intermediate chip select identifier signal corresponding to the first mode in the first mode; and output the first intermediate chip select identifier signal corresponding to the second mode in the second mode; and
a first sampling circuit 121, connected to the first selection circuit 120, and configured to: sample, for one time, the first intermediate chip select identifier signal output by the first selection circuit 120, to obtain the first chip select identifier signal corresponding to the first mode, and sample, for two times, the first intermediate chip select identifier signal output by the first selection circuit 120, to obtain the first chip select identifier signal corresponding to the second mode.

Herein, the first intermediate chip select identifier signal corresponding to the second mode is represented by EVEN_CHK1.

Herein, the first selection circuit 120 is further connected to the first mode flag signal EN_1N and the second mode flag signal EN_2N. The first selection circuit 120 outputs the first intermediate chip select identifier signal corresponding to the first mode by utilizing the first mode flag signal, and the first selection circuit 120 outputs the first intermediate chip select identifier signal corresponding to the second mode by utilizing the second mode flag signal.

Herein, the first sampling circuit 121 may include a half latch 141, a third buffer 144, and a third flip-flop 140. The third flip-flop 140 herein includes a D flip-flop. An input terminal of the half latch 141 is connected to an output terminal of the first selection circuit 120, and receives the first intermediate chip select identifier signal output by the first selection circuit 120, and a clock terminal is connected to the first receiving circuit, and receives the first clock signal, that is, the signal PCLK E, to generate the first chip select identifier signal CS_EVEN_P_B corresponding to the second mode. An output terminal of the half latch 141 is connected to an input terminal of the third buffer 144, and is configured to enhance a signal driving capability. An input terminal of the third flip-flop 140 is connected to an output terminal of the third buffer 144, and a clock terminal is connected to the first receiving circuit, and receives the first clock signal, that is, the signal PCLK_E, to generate the first chip select identifier signal CS_EVEN_P_B_2N corresponding to the first mode.

In some embodiments, the second chip select signal in the first mode overlaps the first chip select signal in the second mode; and the second command signal in the first mode overlaps the first command signal in the second mode.

The first chip select identifier generation circuit 119 includes:
a third NOR gate 128, configured to perform a NOR logical operation on the first command signal and the first chip select signal that are in the first mode;
a second NOT gate 129, configured to perform a NOT logical operation on a logical operation result of the third NOR gate 128, and output the first intermediate chip select identifier signal corresponding to the first mode; and
a third sampling circuit 130, configured to sample, for one time, an inverse signal of the second intermediate chip select identifier signal generated by the second chip select identifier generation circuit 122 in the first mode, to obtain the first intermediate chip select identifier signal corresponding to the second mode.

In some specific examples, the third sampling circuit 130 includes a D flip-flop, and the third sampling circuit 130 may sample the inverse signal of the second intermediate chip select identifier signal in the first mode by utilizing the first complementary clock signal PCLK_O.

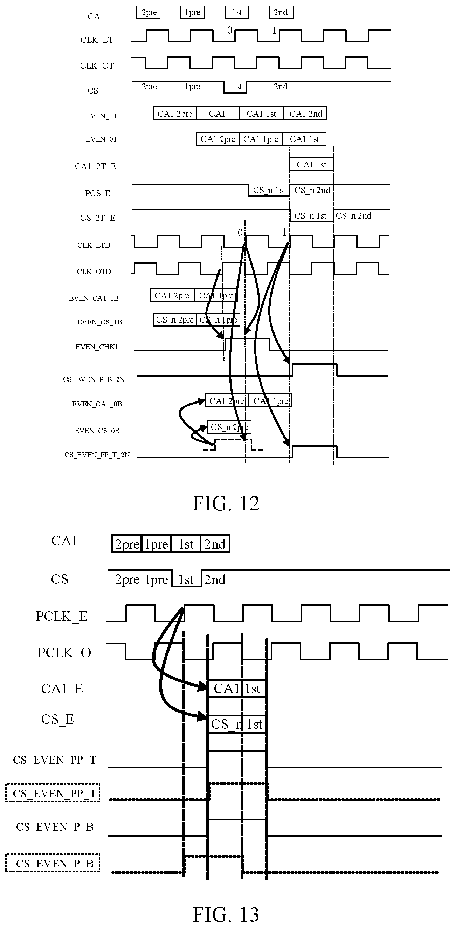

FIG. 11 is a schematic timing diagram in the first mode according to an embodiment of the present disclosure. FIG. 12 is a schematic timing diagram in the second mode according to an embodiment of the present disclosure.

As shown in FIG. 11, in the first mode, when the current chip select signal CS (1st) is at a low level, the current chip select signal is sampled by utilizing PCLK_E and output as CS_E, and is sent to the command decoding circuit. Therefore, CS in the two previous cycles of the cycle needs to be separately checked. The CS in the previous one cycle (1pre) of the cycle is sampled by utilizing PCLK_O and output as ODD _CS_1B, and a logical operation is performed on ODD_CS_1B and CA1 sampling information ODD_CA1_1B in the previous one cycle of the cycle. Then, one stage of flip-flop is added after a logically output signal, and the signal is then sampled by utilizing PCLK_E and output as CS_EVEN_P_B. Similarly, the CS in the previous two cycles (2pre) of the cycle is sampled by utilizing PCLK_E and output as EVEN_CS_1B, and a logical operation is performed on EVEN_CS_1B and CA1 sampling information EVEN_CA1_1B in the previous one cycle of the cycle. One stage of flip-flop is added after an output EVEN_CHK2, and EVEN_CHK2 is then sampled by utilizing PCLK_E and output as CS_EVEN_PP_T. A logical operation is performed by utilizing CS_EVEN_P_B and CS_EVEN_PP_T, to overwrite a decoded command of the current cycle, so as to avoid incorrect decoding in the second cycle of the NT ODT CMD.

As shown in FIG. 12, in the second mode, when the current chip select signal CS (1st) is at a low level, the current chip select signal is sampled by utilizing PCLK_E and output as CS_E, and is sent to the command decoding circuit. Therefore, CS in the two previous cycles of the cycle needs to be separately checked. The CS in the previous one cycle (1pre) of the cycle is sampled by utilizing PCLK_E and output as EVEN_CS_1B, and a logical operation is performed on EVEN_CS_1B and CA1 sampling information EVEN_CA1_1B in the previous one cycle of the cycle. Two stages of flip-flops are added after an output EVEN_CHK1, and EVEN_CHK1 is sampled by utilizing PCLK_E and output as CS_EVEN_P_B_2N. Similarly, the CS in the previous two cycles (2pre) of the cycle is sampled by utilizing PCLK_E and output as EVEN_CS_0B, and a logical operation is performed on EVEN_CS_0B and CA1 sampling information EVEN_CA1_0B in the previous two cycles of the cycle. Two stages of flip-flops are added after an output, and the output signal is sampled by utilizing PCLK_E and output as CS_EVEN_PP_T_2N. A logical operation is performed by utilizing CS_EVEN_P_B_2N and CS_EVEN_PP_T_2N, to overwrite a decoded command of the current cycle, so as to avoid incorrect decoding in the second cycle of the NT ODT CMD.

In some embodiments, as shown in FIG. 10b, the operation circuit includes:
a first operation circuit 132, connected to both the first preprocessing circuit 117 and the second preprocessing circuit 118, and configured to: receive the first chip select identifier signal and the second chip select identifier signal that correspond to the first mode, the first mode flag signal, the current chip select signal, and the current command signal, and output a decoding signal corresponding to the current chip select signal or disable a decoding signal corresponding to the current chip select signal, the first mode flag signal representing that the signal processing circuit is in the first mode; and
a second operation circuit 133, connected to both the first preprocessing circuit 117 and the second preprocessing circuit 118, and configured to: receive the first chip select identifier signal and the second chip select identifier signal that correspond to the second mode, the second mode flag signal, the current chip select signal, and the current command signal, and output a decoding signal corresponding to the current chip select signal or disable a decoding signal corresponding to the current chip select signal, the second mode flag signal representing that the signal processing circuit is in the second mode.

In some embodiments, the first operation circuit 132/the second operation circuit 133 includes an OR gate 134, a first NAND gate 135, a second NAND gate 136, and a fourth NOR gate 137.

An input terminal of the OR gate 134 is configured to receive the first chip select identifier signal and the second chip select identifier signal that correspond to the first mode/the second mode, and an output terminal is connected to one input terminal of the first NAND gate 135.

The other input terminal of the first NAND gate 135 is configured to receive the first mode flag signal/the second mode flag signal, and an output terminal is connected to a first input terminal of the fourth NOR gate 137.

An input terminal of the second NAND gate 136 is configured to receive the current chip select signal and the current command signal, and an output terminal is connected to a second input terminal of the fourth NOR gate 137.

An output terminal of the fourth NOR gate 137 is configured to output the decoding signal corresponding to the current chip select signal or disable the decoding signal corresponding to the current chip select signal.

It should be noted that various logic gates in the command decoding circuit shown in FIG. 10b are merely examples. However, this is not limited to the logic gates shown in FIG. 10b, and there may alternatively be another combination that has a same function as the logic gates in FIG. 10b.

In some specific examples, the first operation circuit 132 includes two second NAND gates 136, and the second operation circuit 133 includes two second NAND gates 136. The second NAND gate 136 in the first operation circuit 132 is configured to receive a current chip select signal CS_E corresponding to the first mode and command/address signals CA0_ E, CA1_E, CA2_E, CA3_E, and CA4_E corresponding to the first mode. The second NAND gate 136 in the second operation circuit 133 is configured to receive a current chip select signal CS_2T_E corresponding to the second mode and command/address signals CA0_2T E, CA1_2T_E, CA22T E, CA3 2T E, and CA4_2T_E corresponding to the second mode.

For the cycle corresponding to the current chip select signal, when the chip select signal corresponding to the current cycle is at a high level, it indicates that the decoding signal corresponding to the chip select signal corresponding to the current cycle needs to be disabled. When the chip select signal corresponding to the current cycle is at a low level, it indicates that the decoding signal corresponding to the chip select signal corresponding to the current cycle may need to be generated. However, whether the decoding signal corresponding to the chip select signal corresponding to the current cycle needs to be necessarily generated needs to be specifically determined with reference to the first chip select signal and the first command signal in the previous one cycle (1pre) of the current chip select signal.

When the first chip select signal is at a high level, it indicates that the current cycle is a first cycle of the NT ODT CMD or the normal CMD, and the decoding signal needs to be generated. When the first chip select signal is at a low level and the first command signal is at a high level, it indicates that the command signal in the previous one cycle of the current cycle corresponding to signal is the normal CMD, and the current cycle is a first cycle of the normal CMD or the NT ODT CMD, and the decoding signal needs to be generated. When both the first chip select signal and the first command signal are at a low level, comprehensive determining needs to be performed with reference to the second command signal and the second chip select signal in the previous two cycles (2pre) of the current chip select signal.

When both the first chip select signal and the first command signal are at a low level, and both the second chip select signal and the second command signal are in the low-level state, it indicates that 1pre and 2pre are two cycles of the NT ODT CMD. When both the first chip select signal and the first command signal are at a low level, the second chip select signal is in the high-level state or the second chip select signal is in the low-level state, and the second command signal is a high-level signal, it indicates that the current cycle is the second cycle of the NT ODT CMD, and the decoding signal corresponding to the current chip select signal needs to be disabled.

Therefore, a case in which the first chip select signal is at a high level or the first command signal is at a high level may be selected from 1pre by utilizing an OR logical operation, so that a result obtained after a logical operation is performed on the first chip select signal and the first command signal is in the high-level state (the disabled state). Alternatively, a case in which both the second chip select signal and the second command signal are at a low level is selected from 2pre by utilizing a NOR logical operation, so that a result obtained after a logical operation is performed on the second chip select signal and the second command signal is in the high-level state (the disabled state).

How to specifically generate, in the first mode, the decoding signal corresponding to the current chip select signal or disable the decoding signal corresponding to the current chip select signal is described below in detail with reference to FIG. 10b.

In the first mode, the corresponding first command signal is ODD _CA1_1B, and the first chip select signal is ODD _CS_1B. After a logical operation is performed through the third NOR gate 128 and the second NOT gate 129, CS_EVEN_P_B is obtained. When one of ODD _CA1_1B and ODD _CS_1B is at a high level, CS_EVEN_P_B is at a high level. Otherwise, CS_EVEN_P_B is at a low level. The second command signal is EVEN_CA1_1B, and the second chip select signal is EVEN_CS_1B. After a logical operation is performed through the first NOR gate 125 and the first NOT gate 126, CS_EVEN_PP_T is obtained. When one of EVEN_CA1_1B and EVEN_CS_1B is at a high level, CS_EVEN_PP_T is at a high level. Otherwise, CS - EVEN_PP is at a low level. A logical operation is performed on CS_EVEN_PP_T and CS_EVEN_P_B through the OR gate 134. When one of CS_EVEN_PP_T and CS_EVEN_P_B is at a high level, a high level is output. Then, a NAND logical operation is performed with the current chip select signal CS_E. When one of CS_EVEN_PP_T and CS_EVEN_P_B is at a high level and the current chip select signal CS_E is in the low-level state, the decoding signal is generated. Otherwise, the decoding signal corresponding to the current chip select signal is disabled.

It may be understood that in this embodiment of the present disclosure, when the current chip select signal is in the low-level state, initial command/address signals CA and initial chip select signals CS in the previous two cycles of the current cycle corresponding to signal are separately checked. If the CS signals in the previous two cycles are at a low level, and the CA1 signal sampling information in the cycles is at a low level, the current CS signal is allowed to be transmitted to the command decoding circuit for command decoding output, and the fourth NOR gate 137 outputs the decoding signal corresponding to the current chip select signal. If the CS signal in the previous one cycle is at a high level, or the CA1 signal sampling information in the cycle is at a high level, the current CS signal is also allowed to be transmitted to the command decoding circuit 114 for command decoding output, and the fourth NOR gate 137 outputs the decoding signal corresponding to the current chip select signal. In the first mode, the current CS signal is sampled by utilizing the signal PCLK_E and output to the command decoding circuit 114, and the CS signals corresponding to the previous two cycles are respectively sampled by utilizing the signal PCLK_E and the signal PCLK_O and output. One stage of sampling circuit is added for each of output signals, the signals are then sampled by utilizing the signal PCLK_E and output as the second chip select identifier signal CS_EVEN_PP_T and the first chip select identifier signal CS_EVEN_P_B, and are sent to the operation circuit, and a logical operation is performed to overwrite a decoded command. In the second mode, the current CS signal is sampled by utilizing PCLK_E and output to the operation circuit, and the CS signals corresponding to the previous two cycles are sampled by utilizing the signal PCLK_E and output. Two stages of sampling circuits need to be added for each of output signals, the signals are sampled by utilizing the signal PCLK_E and output as the second chip select identifier signal CS_EVEN_PP_T_2N and the first chip select identifier signal CS_EVEN_P_B_2N, and are sent to the operation circuit, and a logical operation is performed to overwrite a decoded command. The CS signals corresponding to the two previous cycles are utilized as decoding signals, to avoid incorrect decoding in the second cycle of the NT ODT CMD.

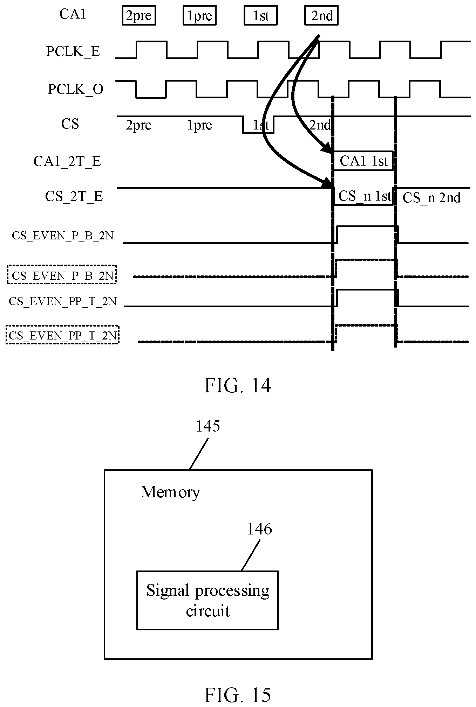

FIG. 13 is a schematic timing diagram of signals corresponding to the first mode. FIG. 14 is a schematic timing diagram of signals corresponding to the second mode. In some embodiments, when the current chip select signal CS is collected, a logical operation is performed by utilizing the second chip select identifier signal CS _EVEN_PP_T in the previous two cycles and the first chip select identifier signal CS _EVEN_P_B in the previous one cycle of the current cycle corresponding to signal CS, to complete CS check for the two previous cycles of the current cycle corresponding to signal CS. In FIG. 13 and FIG. 14, the first chip select identifier signal and the second chip select identifier signal are shown by utilizing dashed lines. In the first mode, a CS check flag signal in the previous one cycle and the current chip select signal CS_n are respectively sampled by utilizing PCLK _E and PCLK_O. Because comparison with chip select signal CS_n is performed after a logical operation is performed on the first chip select identifier signal and the second chip select identifier signal to obtain a determining result, there is a difference of one preset clock cycle. Therefore, a command sampling margin for the flip-flop in the command decoding circuit becomes smaller.

In this embodiment of the present disclosure, in FIG. 13 and FIG. 14, the first chip select identifier signal and the second chip select identifier signal are shown by utilizing solid lines. The signal CS_EVEN_PP _T and the signal CS_EVEN_P_B are transmitted to the operation circuit, and the command signals and the chip select signals in the two previous cycles of the current cycle corresponding to signal are checked at a command decoding input terminal. The current chip select signal and the signals CS_EVEN_PP_T and CS_EVEN_P_B are simultaneously sampled by utilizing PCLK _E/PCLK_O and output to a command decoding end. In this embodiment of the present disclosure, a result obtained after a logical operation is performed on the first chip select identifier signal and the second chip select identifier signal is utilized a decoded command and directly sent to the decoding circuit, to increase a command sampling margin for a next stage of flip-flop.

An embodiment of the present disclosure provides a signal processing circuit, including a command decoding circuit. The command decoding circuit includes: a preprocessing circuit, configured to: receive a first chip select signal corresponding to previous one cycle of a current cycle corresponding to a current chip select signal and a first command signal corresponding to the previous one cycle of the current cycle corresponding to signal, and perform a logical operation on the first chip select signal and the first command signal to generate a first chip select identifier signal; and an operation circuit, connected to the preprocessing circuit, and configured to: receive the first chip select identifier signal and the current chip select signal, and generate a decoded command corresponding to the current chip select signal when the current chip select signal is in an enabled state and the first chip select identifier signal is in a disabled state. In this embodiment of the present disclosure, the preprocessing circuit receives the first chip select signal and the first command signal that correspond to the previous one cycle of the current cycle corresponding to signal, and performs a logical operation to obtain the first chip select identifier signal; and the operation circuit j ointly determines, based on a status of the first chip select identifier signal and a status of the current chip select signal, whether to generate the decoded command corresponding to the current chip select signal, that is, the decoded command corresponding to the current chip select signal is j ointly determined based on at least the current chip select signal and the chip select signal and the command signal that correspond to the previous one cycle of the current cycle corresponding to signal. Therefore, a problem that incorrect decoding is performed in a second cycle of a non-target on-die termination command can be alleviated, thereby increasing a decoding success rate.

According to another aspect of the embodiments of the present disclosure, a memory is further provided. As shown in FIG. 15, the memory 145 includes the signal processing circuit 146 in any one of the foregoing embodiments.

In some embodiments, the memory 145 includes a 5th generation double data rate synchronous dynamic random access memory DDR5.

It should be noted that this embodiment of the present disclosure may be applied to a control circuit for sampling and decoding a CA signal in a DRAM chip, but is not limited to this range. Other related circuits for input signal sampling and command decoding may also utilize this design.

In several embodiments provided in the present disclosure, it should be understood that the disclosed devices and methods may be implemented in a non-target manner. The device embodiments described above are merely examples. For example, the unit division is merely logical function division, and there may be another division manner in actual implementation. For example, multiple units or components may be combined or integrated into another system, or some features may be ignored or not performed. In addition, the displayed or discussed components are coupled to or directly coupled to each other.

The units described as separate parts may or may not be physically separate, and parts displayed as units may or may not be physical units, may be located at one position, or may be distributed on multiple network units. Some or all of the units may be selected according to an actual requirement to achieve the objectives of the solutions of the embodiments.

The features disclosed in the several method or device embodiments provided in the present disclosure may be randomly combined when there is no conflict, to obtain new method embodiments or new device embodiments.

## Claims

1. A signal processing circuit, the signal processing circuit comprising a command decoding circuit (114), and the command decoding circuit (114) comprising:
a preprocessing circuit (115), configured to: receive a first chip select signal corresponding to previous one cycle of a current cycle corresponding to a current chip select signal and a first command signal corresponding to the previous one cycle of the current cycle corresponding to signal, and perform a logical operation on the first chip select signal and the first command signal to generate a first chip select identifier signal; and
an operation circuit (116), connected to the preprocessing circuit, and configured to: receive the first chip select identifier signal and the current chip select signal, and generate a decoded command corresponding to the current chip select signal when the current chip select signal is in an enabled state and the first chip select identifier signal is in a disabled state.

2. The signal processing circuit according to claim 1, wherein the preprocessing circuit is specifically configured to: receive the first chip select signal and a second chip select signal respectively corresponding to the previous one cycle and previous two cycles of the current cycle corresponding to signal and the first command signal and a second command signal respectively corresponding to the previous one cycle and the previous two cycles of the current cycle corresponding to signal, perform a logical operation on the first chip select signal and the first command signal to generate the first chip select identifier signal, and perform a logical operation on the second chip select signal and the second command signal to generate a second chip select identifier signal; and
the operation circuit is specifically configured to: receive the first chip select identifier signal, the second chip select identifier signal, and the current chip select signal, and generate the decoded command corresponding to the current chip select signal when the current chip select signal is in the enabled state and at least one of the first chip select identifier signal and the second chip select identifier signal is in the disabled state.

3. The signal processing circuit according to claim 2, wherein a cycle of the current cycle corresponding to signal in a first mode is equal to one preset clock cycle; and a cycle of the current cycle corresponding to signal in a second mode is equal to two preset clock cycles.

4. The signal processing circuit according to claim 3, wherein the preprocessing circuit comprises:
a first preprocessing circuit (117), configured to: receive a first chip select signal and a first command signal that are in the first mode and a first chip select signal and a first command signal that are in the second mode, and generate first chip select identifier signals respectively corresponding to the first mode and the second mode; and
a second preprocessing circuit (118), configured to: receive a second chip select signal and a second command signal that are in the first mode and a second chip select signal and a second command signal that are in the second mode, and generate second chip select identifier signals respectively corresponding to the first mode and the second mode.

5. The signal processing circuit according to claim 4, wherein the first preprocessing circuit comprises:
a first chip select identifier generation circuit (119), configured to: receive the first chip select signal and the first command signal that are in the first mode and the first chip select signal and the first command signal that are in the second mode, and generate first intermediate chip select identifier signals respectively corresponding to the first mode and the second mode;
a first selection circuit (120), connected to the first chip select identifier generation circuit, and configured to: output the first intermediate chip select identifier signal corresponding to the first mode in the first mode; and output the first intermediate chip select identifier signal corresponding to the second mode in the second mode; and
a first sampling circuit (121), connected to the first selection circuit, and configured to: sample, for one time, the first intermediate chip select identifier signal output by the first selection circuit, to obtain the first chip select identifier signal corresponding to the first mode, and sample, for two times, the first intermediate chip select identifier signal output by the first selection circuit, to obtain the first chip select identifier signal corresponding to the second mode.

6. The signal processing circuit according to claim 5, wherein the second preprocessing circuit comprises:
a second chip select identifier generation circuit (122), configured to: receive the second chip select signal and the second command signal that are in the first mode and the second chip select signal and the second command signal that are in the second mode, and generate second intermediate chip select identifier signals respectively corresponding to the first mode and the second mode;
a second selection circuit (123), connected to the second chip select identifier generation circuit, and configured to: output the second intermediate chip select identifier signal corresponding to the first mode in the first mode; and output the second intermediate chip select identifier signal corresponding to the second mode in the second mode; and
a second sampling circuit (124), connected to the second selection circuit, and configured to: sample, for one time, the second intermediate chip select identifier signal output by the second selection circuit, to obtain the second chip select identifier signal corresponding to the first mode, and sample, for two times, the second intermediate chip select identifier signal output by the second selection circuit, to obtain the second chip select identifier signal corresponding to the second mode.

7. The signal processing circuit according to claim 6, wherein the second chip select identifier generation circuit comprises:
a first NOR gate (125), configured to perform a NOR logical operation on the second command signal and the second chip select signal that are in the first mode;
a first NOT gate (126), configured to perform a NOT logical operation on a logical operation result of the first NOR gate, and output the second intermediate chip select identifier signal corresponding to the first mode; and
a second NOR gate (127), configured to perform a NOR logical operation on the second command signal and the second chip select signal that are in the second mode, and output the second intermediate chip select identifier signal corresponding to the second mode.

8. The signal processing circuit according to claim 6 or 7, wherein the second chip select signal in the first mode overlaps the first chip select signal in the second mode; and the second command signal in the first mode overlaps the first command signal in the second mode; and
the first chip select identifier generation circuit comprises:
a third NOR gate (128), configured to perform a NOR logical operation on the first command signal and the first chip select signal that are in the first mode;
a second NOT gate (129), configured to perform a NOT logical operation on a logical operation result of the third NOR gate, and output the first intermediate chip select identifier signal corresponding to the first mode; and
a third sampling circuit (130), configured to sample, for one time, an inverse signal of the second intermediate chip select identifier signal generated by the second chip select identifier generation circuit in the first mode, to obtain the first intermediate chip select identifier signal corresponding to the second mode.

9. The signal processing circuit according to any one of claims 6 to 8, wherein the first chip select identifier generation circuit/second chip select identifier generation circuit comprises:
a third selection circuit (131), connected to an input terminal of a corresponding NOR gate, and configured to: output a first command/address signal corresponding to the previous one cycle/the previous two cycles of the current cycle corresponding to signal as the first command signal/the second command signal when there is a first layout; and output a second command/address signal corresponding to the previous one cycle/the previous two cycles of the current cycle corresponding to signal as the first command signal/the second command signal when there is a second layout.

10. The signal processing circuit according to any one of claims 4 to 9, wherein the operation circuit comprises:
a first operation circuit (132), connected to both the first preprocessing circuit and the second preprocessing circuit, and configured to: receive the first chip select identifier signal and the second chip select identifier signal that correspond to the first mode, a first mode flag signal, the current chip select signal, and a current command signal, and output a decoding signal corresponding to the current chip select signal or disable a decoding signal corresponding to the current chip select signal, the first mode flag signal representing that the signal processing circuit is in the first mode; and
a second operation circuit (133), connected to both the first preprocessing circuit and the second preprocessing circuit, and configured to: receive the first chip select identifier signal and the second chip select identifier signal that correspond to the second mode, a second mode flag signal, the current chip select signal, and the current command signal, and output a decoding signal corresponding to the current chip select signal or disable a decoding signal corresponding to the current chip select signal, the second mode flag signal representing that the signal processing circuit is in the second mode.

11. The signal processing circuit according to claim 10, wherein the first operation circuit/the second operation circuit comprises an OR gate (134), a first NAND gate (135), a second NAND gate (136), and a fourth NOR gate (137);
an input terminal of the OR gate is configured to receive the first chip select identifier signal and the second chip select identifier signal that correspond to the first mode/the second mode, and an output terminal is connected to one input terminal of the first NAND gate;
the other input terminal of the first NAND gate is configured to receive the first mode flag signal/the second mode flag signal, and an output terminal is connected to a first input terminal of the fourth NOR gate;
an input terminal of the second NAND gate is configured to receive the current chip select signal and the current command signal, and an output terminal is connected to a second input terminal of the fourth NOR gate; and
an output terminal of the fourth NOR gate is configured to output the decoding signal corresponding to the current chip select signal or disable the decoding signal corresponding to the current chip select signal.

12. The signal processing circuit according to any one of claims 3 to 11, wherein the signal processing circuit further comprises a clock processing circuit (201); and
the clock processing circuit is configured to: receive a source clock signal, and output an initial clock signal and an initial complementary clock signal, a clock cycle of the source clock signal being the same as the preset clock cycle, a clock cycle of each of the initial clock signal and the initial complementary clock signal being equal to the clock cycle of the source clock signal, and a phase difference between the initial clock signal and the initial complementary clock signal being 180 degrees.

13. The signal processing circuit according to claim 12, wherein the signal processing circuit further comprises:
a first receiving circuit (202), configured to: receive the initial clock signal and the initial complementary clock signal, and output a first clock signal and a first complementary clock signal, a clock cycle of each of the first clock signal and the first complementary clock signal being twice the clock cycle of the source clock signal;
a second receiving circuit (203), configured to: receive a source command/address signal, and output an initial command/address signal; and
a third receiving circuit (204), configured to: receive a source chip select signal, and output an initial chip select signal.

14. The signal processing circuit according to claim 13, wherein the signal processing circuit further comprises:
a chip select processing circuit (206), connected to the first receiving circuit and the third receiving circuit, and configured to: receive the initial chip select signal, and sample the initial chip select signal for one time by utilizing the first clock signal/the first complementary clock signal, to obtain the second chip select signal; sample the second chip select signal for one time by utilizing the first clock signal/the first complementary clock signal, to obtain the first chip select signal; and sample the first chip select signal for one time by utilizing the first clock signal/the first complementary clock signal, to obtain the current chip select signal; and
a command/address processing circuit (205), connected to the first receiving circuit and the second receiving circuit, and configured to: receive the initial command/address signal, and sample the initial command/address for one time by utilizing the first clock signal/the first complementary clock signal, to obtain the second command signal; sample the second command signal for one time by utilizing the first clock signal/the first complementary clock signal, to obtain the first command signal; and sample the first command signal for one time by utilizing the first clock signal/the first complementary clock signal, to obtain the current command signal.

15. A memory (145), wherein the memory comprises the signal processing circuit (146) according to any one of claims 1 to 14.

16. The memory according to claim 15, wherein the memory comprises a 5th generation double data rate synchronous dynamic random access memory, DDR5 SDRAM.
